Europäisches Patentamt

European Patent Office

Office européen des brevets

(11) Publication number: **0 115 035**
**B1**

(12) **EUROPEAN PATENT SPECIFICATION**

(45) Date of publication of patent specification: **30.11.88**

(51) Int. Cl.⁴: **H 01 L 23/54,** H 01 L 23/28

(21) Application number: **83112888.9**

(22) Date of filing: **21.12.83**

(54) **Semiconductor structure tolerant to ionizing radiation.**

(30) Priority: **31.01.83 US 462282**

(43) Date of publication of application:
**08.08.84 Bulletin 84/32**

(45) Publication of the grant of the patent:
**30.11.88 Bulletin 88/48**

(84) Designated Contracting States:
**DE FR GB**

(56) References cited:
EP-A-0 033 159
WO-A-82/04162
US-A-4 042 945
US-A-4 364 779

INTERNATIONAL ELECTRON DEVICES
MEETING, 3rd-5th December 1979,
Washington, pages 629-632, IEEE, New York,
US; N. BLUZER et al.: "Radiation hard charge-
coupled device operating at 77 K using
nitride/oxide gate insulators"

(73) Proprietor: **International Business Machines
Corporation
Old Orchard Road
Armonk, N.Y. 10504 (US)**

(72) Inventor: **Cottrell, Peter Edwin
26 Lincoln Street
Essex Junction Vermont 05452 (US)**
Inventor: **Garnache, Richard Raymond
1400 Spear Street
South Burlington Vermont 05401 (US)**
Inventor: **Geipel, Henry John, Jr.
1 Alderbrook Road
Essex Junction Vermont 05452 (US)**
Inventor: **Troutman, Ronald Roy
7 Rustic Drive
Essex Junction Vermont 05452 (US)**

(74) Representative: **Möhlen, Wolfgang C., Dipl.-Ing.
IBM Corporation Säumerstrasse 4
CH-8803 Rüschlikon (CH)**

(56) References cited:
IBM TECHNICAL DISCLOSURE BULLETIN, vol.
22, no. 4, September 1979, pages 1460-1461,
New York, US; J.A. BRODY et al.: "Storage and
logic errors in dynamic memory devices due to
innate radioactive materials in packaging and
wafer"

Courier Press, Leamington Spa, England.

## Description

This invention relates in general to radiation resistant semiconductor devices and in particular to field effect transistor devices with isolation structures which are tolerant to radiation.

Semiconductor devices and especially devices which include Metal-Insulator-Silicon (MIS) structures are sensitive to radiation. MIS structures, such as Metal-Oxide-Silicon (MOS) transistors, are characterized by a threshold voltage value which must be exceeded by a voltage signal applied on the metal gate electrode of the device in order to permit the flow of current through the channel region of the transistor. When such devices are exposed to radiation, such as that which is present in outer space or during nuclear explosions they suffer a change in their electrical characteristics, such as their threshold voltage value, which is primarily caused by the radiation induced generation of charges in the insulator of the devices. These charges move under the influence of the electric field until they recombine or are trapped into trapping centers that exist within the insulator or at locations at the insulator-silicon interface. Under most conditions, more holes than electrons become trapped and the result is a net positive charge within the insulator. This results in a change in the threshold voltage of the MIS structure.

Integrated MOS circuits have a number of active Field Effect Transistor (FET) device portions separated from each other by isolation structures made of insulating layers adjacent to the substrate that normally form with the substrate and adjoining metallic structures MIS type of devices. These are normally inactive portions which under certain conditions become parasitic structures detrimental to the normal operation of the active device portions. For example, in the presence of ionizing radiation, charges are generated in all insulating layers that receive the radiation. However, since the insulating layers of the inactive portions are much thicker than the insulating layers of the active portions, there will be a much bigger quantity of charge generated and trapped in the insulating layers of the inactive portions than in the insulating layers of the active portions. Furthermore, since the bias voltage that is normally applied across the insulating layers of the active portions is much larger than the average voltage that often exists across the insulating layers of the inactive portions, the effect of these trapped charges on the threshold voltage of parasitic MIS structures is much larger than their equivalent on the active MIS structures.

Many efforts have been made to develop MIS devices, and processes for making the same, which are tolerant of the presence of ionizing radiation. Following are references which describe some of the typical approaches used for this purpose.

In U.S. Patent 3,999,209, a layer of chromium is on top of the gate insulating layer, and a diffused portion of that chromium is inside the insulating layer, to reduce the effects of radiation on the threshold voltage of the device.

In U.S. patent 3,829,961, there is shown a method for improving the radiation resistance of devices by irradiating the boundary layer between the silicon and the silicon dioxide layer with electrons of a certain dose, at a certain energy level, while the device is maintained at an elevated temperature.

In U.S. Patent 3,872,492, there is disclosed a radiation hardened FET in which an insulator comprised of an amorphous insulating semiconductor material is substituted for the conventional dielectric insulators of FET's. Such a material has very few traps for charges to be trapped and affect the threshold voltage of the device.

In U.S. Patent 3,882,530 there is disclosed a method for radiation hardening MOS devices wherein boron or some other acceptor impurity is introduced into the insulating oxide close to the semiconductor insulator interface of the device to reduce the radiation induced positive gate charge accumulations.

In U.S. Patent 3,886,584 there is disclosed an MIS device which is radiation hardened by having an open space between the metal layer of the gate and the insulating layer of the device. The purpose of the open space is to reduce the gate insulator's capability to assume or to retain electrical charge produced in the presence of radiation.

In U.S. Patent 4,148,049, there is shown a radiation hardened MNOS transistor having the gate electrode in contact with both the silicon nitride and the silicon oxide layers. If, during irradiation, charges build up in the silicon dioxide, they will be able to escape through the gate electrode.

All of the above noted patents disclose devices with special gate insulating structures in the active FET device portions to increase their tolerance to radiation. However, none of them teaches any specific way for meeting the special need to minimize the effect of ionization caused by radiation in inactive device portions. As noted above, these structures are usually more sensitive to threshold changes. At the same time they do not always have the thickness constraints that gate insulating materials for the active FET portions have to meet. The expanding use of N-channel MOS (N-MOS) devices for many applications and the special sensitivity of these devices to ionizing radiation has resulted in a need for structures with electrical characteristics which are substantially unaltered in a radiation environment. N-MOS devices are in greater need for radiation resistant isolation structures because their positive gate potential causes the generated holes to move towards the insulating layer-substrate interface where they can cause the depletion of the adjoining portion of the substrate from its electrons and thus cause the inversion of the underlying portion of the substrate from P-type into N-type, and increase the leakage currents between the active transistor portions.

It is therefore an object of this invention to provide a semiconductor structure with an improved tolerance to ionizing radiation for electrically isolating active field effect transistor devices.

The present invention achieves all this object by providing a semiconductor structure for electrically insulating active field effect transistor portions, with improved tolerance to ionizing radiation, which includes a semiconductor substrate of a given type of conductivity and a plurality of insulating layers adjacent the substrate. A first insulating layer forms with the substrate an insulating-layer-to-substrate interface and each successive insulating layer forms with its adjacent insulating layer an insulating-layer-to-insulating-layer interface.

These interfaces form trapping centers in which charge generated in the insulating layers can be trapped. The thickness and dielectric constant of each insulating layer are predetermined so that in the presence of ionizing radiation enough of the charges generated in the insulating layers will be trapped and electrically neutralized in the insulating-layer-to-insulating-layer interfaces so that the remaining generated charges which may be trapped in the substrate-to-the first insulating layer interface will be insufficient to deplete the adjoining portion of the substrate from its mobile charge carriers and to invert it into a region of the opposite conductivity type. Thus, devices, which include structures in accordance with present invention to electrically isolate the active field effect transistor portions, will be able to operate in the presence of ionization radiation without any significant increase in leakage current.

The advantages of the invention will be apparent from the following and more particular description of the preferred embodiments of the invention, as illustrated in the accompanying drawings.

Fig. 1 is a diagrammatic cross-sectional view of a semiconductor structure that electrically insulates two active field effect transistor portions constructed in accordance with the teachings of the present invention on a common substrate.

Fig. 2 is a diagrammatic cross-sectional view of the portion of the structure shown in Fig. 1, in the presence of ionizing radiation.

Fig. 3 illustrates the claimed structure's maximum hardening efficiency as a function of the ratio of thickness for its two insulating layers.

Fig. 4 is a diagrammatic cross-sectional view of another structure embodying the present invention.

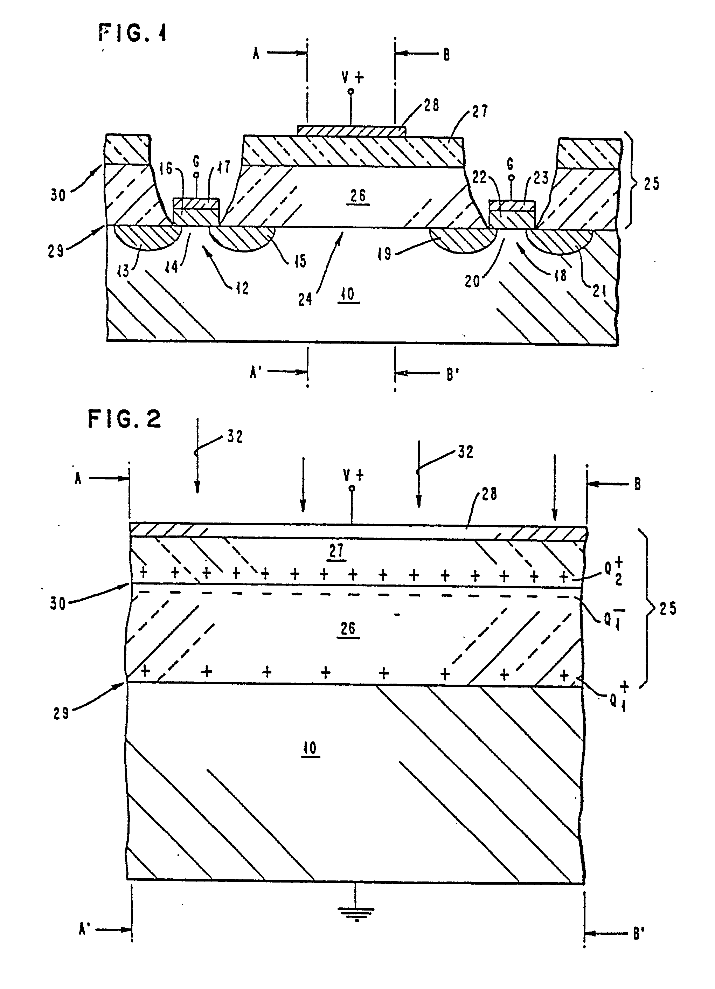

Referring now to Fig. 1, there is shown a diagrammatic cross-sectional view of a semiconductor structure constructed in accordance with the present invention. It includes a semi-insulating semiconductor substrate 10 on which there are two active FET portions 12 and 18. Active transistor portion 12 includes source region 13, channel region 14 and drain region 15.

A gate insulating layer 16 is adjacent the channel region 14. Gate electrode 17 is adjacent the gate insulating layer 16. Active transistor portion 18 includes source region 19, channel region 20 and drain region 21. A gate insulating layer 22 is adjacent channel region 20. Gate electrode 23 is adjacent layer 22. Between active transistor portions 12 and 18 there is an inactive semiconductor portion 24 which is used to electrically insulate the active transistor portions 12 and 18. An insulating structure 25 is adjacent inactive semiconductor portion 24 and adjacent parts of the active portions 12 and 18. A gate electrode 28 is adjacent insulating structure 25. Structure 25 is often referred to as field insulating structure (or field oxide if it is made of a single layer of silicon dioxide) and according to the teachings of this invention it consists of a plurality of insulating layers. This field insulating structure has a thickness which is much greater than that of the gate insulating layers 16 and 22 for active portions 12 and 18. Typically, the thickness of structure 25 is on the order of 20 times the thickness of the gate insulating layers 16 and 18. Gate electrode 28 represents the electrically conductive traces that pass over the field insulating structure. Thus, the structure comprising electrode 28, insulating structure 25 and semiconductor substrate 10 forms an MIS type of a structure between FET portions 12 and 18. In one particular embodiment of this invention, the semi-insulating semiconductor substrate 10 is silicon having a P-type conductivity, regions 13, 15, 19 and 21 have N-type conductivity, gate insulating layers 16 and 22 are silicon dioxide ($SiO_2$) layers and the field insulating structure 25 consists of a silicon dioxide ($SiO_2$) layer 26 and a silicon nitride ($Si_3N_4$) layer 27. Although most discussion in this specification deals with N-channel devices, the same principles apply to the fabrication of both N- and P-type devices. The N-channel devices were selected for this discussion because they are most sensitive to radiation as discussed earlier in the background section. Similarly, while the discussion focuses on devices that have silicon substrates and silicon dioxide for at least one of their insulating layers, there is nothing to limit the invention to this combination of materials.

In general, every MIS type of a structure undergoes changes in the presence of ionizing radiation. The threshold voltage of these structures changes and the resulting threshold voltage shift $\Delta V_T$ can be approximated by the following equation:

$$\Delta V_T = \frac{K}{\varepsilon} t_{in}^2 \, D \, \gamma$$

where K is a proportionality constant, $\varepsilon$ is the dielectric constant of the insulating layer, $t_{in}$ is the thickness of the insulating layer (assuming a single insulating layer), D is the radiation dose and $\gamma$ is the fractional yield of charges trapped in the insulating layer. This equation illustrates the close relationship between the thickness of the insulating layer and the threshold voltage shift caused by the presence of ionizing radiation. However, a device made in accordance with the teachings of this invention, for example, as shown in Fig. 1, is not affected nearly as much as prior art devices by the presence of ionizing radiation. This is due to the construction of the insulating structure which uses a plurality of insulating layers of predetermined thickness and dielectric constant. This improvement is better illustrated in Fig. 2 which shows a section of the device shown in Fig. 1, along lines AA' and BB', which is the section between the two active FET portions, in the presence of ionizing radiation.

Referring now to Fig. 2, there is shown a portion of the structure of Fig. 1 between lines AA' and BB', including silicon substrate 10, silicon dioxide layer 26, silicon nitride layer 27 and the gate electrode 28, in the presence of ionizing radiation 32. When a dose D of radiation 32 impinges on the structure shown in Fig. 2, in the presence of a positive gate bias V+, holes will be created in layer 26 and they will move to the silicon-silicon dioxide interface 29 where a fraction $\gamma_1$ of them will be trapped and the remaining will recombine. The charge due to the trapped holes in interface 29 will be

$$Q^+_1 = \gamma_1 \, K_{ox} \, D \, T_{ox}$$

where $K_{ox}$ is the proportionality constant for $SiO_2$, and $T_{ox}$ is the thickness of $SiO_2$ layer 26. Because of the existence of the $SiO_2$—$Si_3N_4$ interface 30, the drifting radiation-generated electrons that survive recombination are trapped in interface 30 and set up a charge $Q_1^-$ which will be

$$Q_1^- = \gamma_2 \, K_{ox} \, D \, T_{ox}$$

where $\gamma_2$ is the fractional yield ($\gamma_2 \leq 1$) of electrons in the $SiO_2$ layer 26. $\gamma_1$ and $\gamma_2$ have in general different values because of the different interface trapping probabilities for holes and electrons.

The radiation effects in the nitride layer are similar. Holes generated therein move to the $Si_3N_4$—$SiO_2$ interface 30 where they are trapped and electrons move to the gate electrode 28 where they are either collected or imaged. The charge due to the trapped hole is:

$$Q_2^+ = \gamma_3 \, K_N \, D \, T_N$$

where $\gamma_3$ is the fractional yield of holes in the $Si_3N_4$ layer, $K_N$ is the proportionality constant for $Si_3N_4$ and $T_N$ in the thickness of $Si_3N_4$ layer 27.

Thus, the threshold voltage shift ($\Delta V_{T,DD}$) in the dual dielectric structure 25 is

$$\Delta V_{T,DD} = -\frac{\gamma_1 \, D \, K_{ox} \, T_{ox}^2}{\varepsilon_{ox}} + \frac{(\gamma_2 - \gamma_1) \, D \, K_{ox} \, T_{ox} \, T_N}{\varepsilon_N}$$
$$-\gamma_3 \frac{D \, K_N \, T_N^2}{\varepsilon_N}$$

For comparison purposes the threshold voltage shift of a single insulating film ($\Delta V_{T,SD}$) of the equivalent $SiO_2$ thickness is given by

$$\Delta V_{T,SD} = -\gamma_1 \frac{D \, K_{ox} \, T_{ox,equ.}^2}{\varepsilon_{ox}} =$$
$$= -\gamma_1 \frac{D \, K_{ox} \, T_{ox}^2}{\varepsilon_{ox}} \left(1 + \frac{\varepsilon_{ox}}{\varepsilon_N} \frac{T_N}{T_{ox}}\right)^2$$

If the hardening efficiency of the dual dielectric structure ($SiO_2$—$SiN_4$) over the equivalent single ($SiO_2$) structure is defined as

$$H = \frac{\Delta V_{T,SD} - \Delta V_{T,DD}}{\Delta V_{T,SD}} = 1 - \frac{\Delta V_{T,DD}}{\Delta V_{T,SD}}$$

then, the maximum hardening efficiency is $H = 1$ when the threshold voltage shift for the dual dielectric structure (25) is zero. Thus, the hardening efficiency H, which is independent of D (the radiation dose), can be written in terms of the film thickness ratio

$$x = \frac{T_N}{T_{ox}}$$

as

$$H = \frac{r(2+a) \, x - r \, (b-r) \, x^2}{(1+rx)^2}$$

where

$$a = \frac{\gamma_2}{\gamma_1} - 1;$$

$$b = \frac{\gamma_3}{\gamma_1} \frac{K_N}{K_{ox}};$$

and

$$r = \frac{\varepsilon_{ox}}{\varepsilon_N}$$

Semiconductor test structures constructed in accordance with the teachings of the invention having an insulating structure composed of an $SiO_2$ layer of 29 nm (290 Å) and an $Si_3N_4$ layer of 32 nm (320 Å) (the combination being the electrical equivalent of 47.3 nm (473 Å) of a single $SiO_2$ layer) were exposed to various dose levels of $^{60}Co$ radiation, in the range of $10^4$ Rads, and were tested for the changes in their threshold voltage. The resulted threshold voltage shifts measured were in the range of 40—100 mV. Semiconductor devices with insulated structures made up entirely of $SiO_2$ and with a thickness of approximately 45 nm (450 Å) exhibited threshold shifts close to 970 mV when exposed to the same radiation doses.

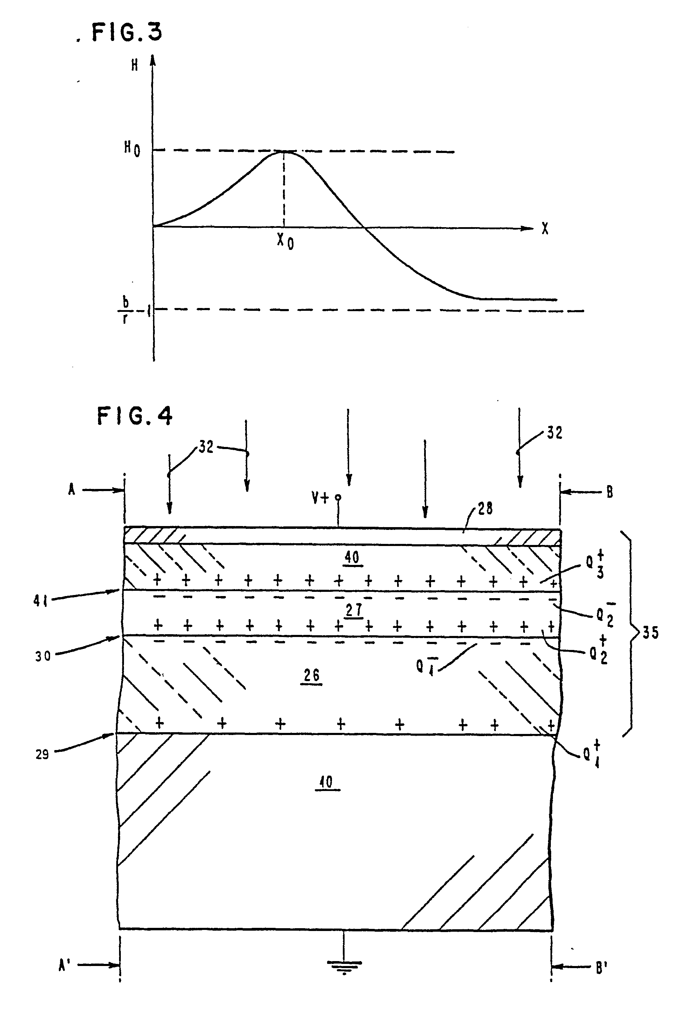

In Fig. 3 there is shown the hardening efficiency of the device shown in Fig. 1, as a function of the ratio of thickness for its two insulating layers (25, 26).

The maximum hardening efficiency can be obtained by a proper selection of the relative thicknesses of the two insulation layers in accordance with the following equations:

With

$$X=\frac{T_N}{T_{ox}}=X_o=\frac{\dfrac{Y_2}{Y_1}+1}{r\left(\dfrac{Y_2}{Y_1}-1+\dfrac{2}{r}\dfrac{Y_3}{Y_1}\dfrac{K_N}{K_{ox}}\right)}$$

the maximum hardening $H_o$ will be:

$$H_o=\frac{\left(\dfrac{Y_2}{Y_1}+1\right)^2}{4\left(\dfrac{Y_2}{Y_1}+\dfrac{\varepsilon_N}{\varepsilon_{ox}}\dfrac{Y_3}{Y_1}\dfrac{K_N}{K_{ox}}\right)}$$

The hardening efficiency will be minimum when the recombination is negligible and all the radiation induced charges are trapped in the interfaces. Then

$$Y_1=Y_2=Y_3=1$$

and

$$X_o=\frac{K_{ox}}{K_N}\cong0.63$$

and

$$H_o=\frac{1}{1+\dfrac{\varepsilon_N}{\varepsilon_{ox}}\dfrac{K_N}{K_{ox}}}\cong0.26$$

In a more realistic case, when $Y_1=0.25$ and $Y_2=Y_3=1$, then

$$X_o=\frac{\dfrac{K_{ox}}{K_N}}{1.6+0.6\dfrac{\varepsilon_{ox}}{\varepsilon_N}\dfrac{K_{ox}}{K_N}}\cong0.35$$

and

$$H_o=\frac{1.56}{1+\dfrac{\varepsilon_N}{\varepsilon_{ox}}\dfrac{K_N}{K_{ox}}}\cong0.41$$

In Fig. 4, there is shown another embodiment of this invention which can achieve even greater hardening efficiencies. This is a structure similar to that of Fig. 2 except that the insulating structure 35 of Fig. 4 has three insulating layers. There is an $SiO_2$ layer 26 (which can be a thermally grown layer), an $Si_3N_4$ layer 27 (which can be made using a chemical vapor deposition process) and any $SiO_2$ layer 40 (which can be made with a chemical vapor deposition process). This structure has an additional insulating-layer-to-insulating-layer interface 41 which will trap and neutralize the effects of additional charge that would otherwise contribute to the threshold voltage shift of the device. If $Y=1$ and $Tox_2=Tox_1$ then the resulting threshold shift is caused by $Q_1^+$ only and is given by:

$$\Delta V_T=-\frac{D\,T_{ox_1}\,K_{ox}}{\varepsilon_{ox}}\left(T_{ox_1}+\frac{\varepsilon_{ox}}{\varepsilon_N}T_N+T_{ox_2}\right)$$

so that the hardening efficiency of the structure shown in Fig. 4 is:

$$H=1-\frac{T_{ox_1}}{T_{ox_1}+\dfrac{\varepsilon_{ox}}{\varepsilon_N}T_N+T_{ox_2}}$$

$$=\frac{T_{ox_2}+\dfrac{\varepsilon_{ox}}{\varepsilon_N}T_N}{T_{ox_1}+T_{ox_2}+\dfrac{\varepsilon_{ox}}{\varepsilon_N}T_N}$$

$$=\frac{1+\dfrac{K_{ox}}{K_N}\dfrac{\varepsilon_{ox}}{\varepsilon_N}}{2+\dfrac{K_{ox}}{K_N}\cdot\dfrac{\varepsilon_{ox}}{\varepsilon_N}}\cong0.57$$

In a more general case with an insulating structure comprising m $SiO_2$ layers and n $Si_3N_4$ alternating layers, the worst case for the hardening efficiency is:

$$H=\frac{m+n\dfrac{\varepsilon_{ox}}{\varepsilon_N}\dfrac{K_{ox}}{K_N}}{(m+1)+n\dfrac{\varepsilon_{ox}}{\varepsilon_N}\dfrac{K_{ox}}{K_N}}\cong\frac{m+0.35\,n}{(m+1)+0.35\,n}$$

because the ratio of dielectric constants is

$$\frac{\varepsilon_{ox}}{\varepsilon_N}=\frac{3.9}{7.0}=0.56,$$

and the ratio of proportionality constants is inversely related to the ratio of energy band gaps of the insulating materials, which for these materials is:

$$\frac{K_{ox}}{K_N} = \frac{\varepsilon_{g,N}}{\varepsilon_{g,ox}} \cong \frac{5}{8.1} = 0.62$$

## Claims

1. A semiconductor structure tolerant to ionizing radiation, having at least one inactive portion located between and electrically isolating active field effect transistor devices, characterized by a semiconductor substrate (10) having a given type of conductivity, and a plurality (25, 35) of adjacent insulating layers over each said inactive portion (24) forming a field insulating structure; an MIS structure being formed by an electrode (28) over said field insulating structure; said field insulating structure having a thickness which is much greater than that of the gate insulating layers (16, 22) of said active field effect transistor devices; said plurality of insulating layers including a first layer (26) adjacent to said substrate and forming with said substrate an insulating-layer-to-substrate interface (29), each successive insulating layer (27, 40) being adjacent to the previous one and forming with the previous insulating layer an insulating-layer-to-insulating-layer interface (30, 41), the thickness and the dielectric constant of each insulating layer being predetermined so that in the presence of ionizing radiation enough of the electrical charges generated in the insulating layers will be trapped and electrically neutralized in said insulating-layer-to-insulating-layer interfaces (30, 41) so that any remaining charges trapped in said insulating-layer-to-substrate interface (29) will be insufficient to significantly deplete the adjoining portion (24) of said substrate from its mobile charge carriers and cause it to invert into a region of the opposite conductivity type.

2. A semiconductor structure as set forth in claim 1, wherein:

said semiconductor substrate (10) is silicon, and

said plurality (25, 35) of insulating layers comprises a layer of silicon dioxide (26) adjacent said substrate and a layer of silicon nitride (27) adjacent said layer of silicon dioxide.

3. A semiconductor structure as set forth in claim 2, wherein the ratio of the thickness of said silicon nitride layer (27) to the thickness of said silicon dioxide layer (26) is substantially equal to 0.63.

4. A semiconductor structure as set forth in claim 1, wherein:

said semiconductor substrate (10) is silicon, and

said plurality (35) of insulating layers comprises a series of alternating layers of silicon dioxide (26, 40) and silicone nitride (27).

5. A semiconductor structure as set forth in claim 1, wherein:

said semiconductor substrate (10) is silicon, and

said plurality (35) of insulating layers comprises a first layer of silicon dioxide (26) adjacent said substrate, a layer of silicon nitride (27) adjacent said first layer of silicon dioxide and a second layer of silicon dioxide (40) adjacent said silicon nitride layer.

## Patentansprüche

1. Halbleiterstruktur, die gegen ionisierende Strahlung tolerant ist, mit mindestens einem inaktiven Teilbereich, welcher zwischen aktiven Feldeffekttransistor - Vorrichtungen liegt und diese elektrisch voneinander isoliert, gekennzeichnet durch ein Halbleitersubstrat (10) eines bestimmten Leitungstyps und eine Mehrzahl (25, 35) von benachbarten Isolationsschichten über jedem der inaktiven Bereiche (24), welche eine Feldisolationsstruktur bilden; ferner dadurch gekennzeichnet, dass durch eine Elektrode (28) über der Feldisolationsstruktur eine MIS-Struktur gebildet wird; dass die Feldisolationstruktur eine Dicke hat, die erheblich grösser ist als die der Gate - Isolationsschichten (16, 22) der aktiven Feldeffekttransistor - Vorrichtungen; dass die Mehrzahl von Isolationsschichten eine erste Schicht (26) enthält, welche dem Substrat benachbart ist und mit diesem Substrat eine Isolationsschicht/Substrat - Kontaktfläche bildet (29), und dass jede der folgenden Isolationsschichten (27, 40) der vorhergehenden benachbart ist und mit der vorhergehenden Isolationsschicht eine Isolationsschicht/Isolationsschicht - Kontaktfläche (30, 41) bildet, dass die Dicke und die Dielektrizitätskonstante jeder Isolationsschicht so vorherbestimmt sind, dass bei ionisierender Strahlung ausreichend viele der elektrischen Ladungen, die in den Isolationsschichten gebildet werden, in den Isolationsschicht/Isolationsschicht - Kontaktflächen (30, 41) eingefangen und elektrisch neutralisiert werden, so dass etwaige verbleibende Ladungen, die in der Substrat/Isolationsschicht - Kontaktfläche eingefangen wurden, nicht ausreichen, um den benachbarten Teilbereich (24) des Substrates von seinen mobilen Ladungsträgern zu verarmen und dadurch in in einen Bereich des entgegengesetzten Leitungstyps zu verwandeln.

2. Halbleiterstruktur gemäss Anspruch 1, in welcher

das Halbleitersubstrat (10) aus Silizium besteht, und

die Mehrzahl (25, 35) von Isolationsschichten eine Schicht aus Siliziumdioxid (26) umfasst, welche dem Substrat benachbart ist, sowie eine Schicht aus Siliziumnitrid (26), welche der Schicht aus Siliziumdioxid benachbart ist.

3. Halbleiterstruktur gemäss Anspruch 2, in welcher das Verhältnis der Dicke der Siliziumnitridschicht (27) zur Dicke der Siliziumdioxidschicht (26) im wesentlichen gleich 0,63 ist.

4. Halbleiterstruktur gemäss Anspruch 1, in welcher

das Halbleitersubstrat (10) aus Silizium besteht, und

die Mehrzahl von Isolationsschichten (35) eine Reihe von abwechselnden Schichten aus Siliziumdioxid (26, 40) und Siliziumnitrid (40) umfasst.

5. Halbleiterstruktur gemäss Anspruch 1, in welcher

die Mehrzahl (35) von Isolationsschichten eine erste Schicht aus Siliziumdioxid (26) umfasst, welche dem Substrat benachbart ist, eine Schicht aus Siliziumnitrid (27), welche der ersten Schicht aus Siliziumdioxid benachbart ist, und eine zweite Schicht aus Siliziumdioxid (40), welche der Siliziumnitridschicht benachbart ist.

## Revendications

1. Structure semiconductrice résistant aux radiations ionisantes, ayant au moins une partie inactive localisée entre et isolant électriquement des dispositifs actifs à transistors à effet de champ, caractérisée par un substrat semiconducteur (10) ayant un type donné de conductivité et une pluralité (25, 35) de couches isolantes adjacentes au-dessus de chaque partie inactive (24) formant une structure d'isolement de champ; et une structure MIS formée par une électrode (28) au-dessus de ladite structure d'isolement de champ; ladite structure d'isolement de champ ayant une épaisseur qui est beaucoup plus grande que celle des couches d'isolement de grille (16, 22) desdits dispositifs actifs à transistors à effet de champ; ladite pluralité de couches isolantes comprenant une première couche (26) adjacente audit substrat et formant avec ledit substrat une interface couche isolante—substrat (29), chaque couche isolante successive (27, 40) étant adjacente à la précédente et formant avec la précédente couche isolante une interface couche isolante—couche isolante (30, 41), l'épaisseur et la constante diélectrique de chaque couche isolante étant prédéterminées de façon qu'en la présence de radiations ionisantes, suffisamment de charges électriques générées dans les couches semiconductrices soient piégées et électriquement neutralisées auxdites interfaces couche isolante—couche isolante (30, 41) de sorte que de quelconques charges restantes piégées à ladite interface couche isolante-substrat (29) ne soient pas suffisantes pour dépeupler de façon significative la partie adjacente (24) dudit substrat de ses porteurs de charge mobiles et pour faire qu'elle s'inverse en une région du type opposé de conductivité.

2. Structure semiconductrice selon la revendication 1, dans laquelle:

le substrat semiconducteur (10) est du silicium, et

ladite pluralité (25, 35) de couches isolantes comprend une couche de dioxyde de silicium (26) adjacente audit substrat et une couche de nitrure de silicium (27) adjacente à ladite couche de dioxyde de silicium.

3. Structure semiconductrice selon la revendication 2, dans laquelle le rapport de l'épaisseur de ladite couche de nitrure de silicium (27) sur l'épaisseur de ladite couche de dioxyde de silicium (26) est sensiblement égal à 0,63.

4. Structure semiconductrice selon la revendication 1, dans laquelle:

le substrat semiconducteur (10) est du silicium, et

ladite pluralité (35) de couches isolantes comprend une série de couches alternées de dioxyde de silicium (26, 40) et de nitrure de silicium (27).

5. Structure semiconductrice selon la revendication 1, dans laquelle:

le substrat semiconducteur (10) est du silicium, et

ladite pluralité (35) de couches isolantes comprend une première couches de dioxyde de silicium (26) adjacente audit substrat, une couche de nitrure de silicium (27) adjacente à ladite première couche de dioxyde de silicium, et une seconde couche de dioxyde de silicium (40) adjacente à ladite couche de nitrure de silicium.

**FIG. 1**

**FIG. 2**

. FIG.3

FIG.4